# EUROPÄISCHE PATENTSCHRIFT

(11) **EP 0 897 593 B1**
(45) Veröffentlichungstag und Bekanntmachung des Hinweises auf die Patenterteilung: **26.09.2001**
(21) Anmeldenummer: 97919305.9
(22) Anmeldetag: 27.03.1997
(51) Int. Cl.: H01L 21/00

(54) **VORRICHTUNG UND VERFAHREN ZUM BEHANDELN VON SUBSTRATEN IN EINEM FLUID-BEHÄLTER**
DEVICE AND PROCESS FOR TREATING SUBSTRATES IN A FLUID CONTAINER
PROCEDE ET DISPOSITIF POUR TRAITER DES SUBSTRATS DANS UN RECIPIENT POUR FLUIDE

(30) Priorität: 22.04.1996 DE 19615969; 17.12.1996 DE 19652526
(43) Veröffentlichungstag der Anmeldung: 24.02.1999
(73) Patentinhaber: STEAG MicroTech GmbH, 72124 Pliezhausen (DE); IMEC vzw, 3001 Leven (BE)
(72) Erfinder: WEBER, Martin, D-78073 Bad Dürrheim (DE); MEURIS, Marc, B-3140 Keerbergen (BE); CORNELISSEN, Ingrid, B-3930 Hamont-Achel (BE)
(74) Vertreter: Wagner, Karl H., Dipl.-Ing.
(86) Internationale Anmeldenummer: EP9701575
(87) Internationale Veröffentlichungsnummer: WO9740523

(56) Entgegenhaltungen:
- WO-A-95/02473
- DE-A- 4 413 077
- JP-A- 60 106 135
- US-A- 4 987 407
- US-E- R E33 341

## Beschreibung

Die Erfindung betrifft eine Vorrichtung zum Behandeln von Substraten in einem Fluid-Behälter mit einer über den Fluid-Behälter bringbaren Transporteinrichtung, die wenigstens eine Substrat-Halteeinrichtung aufweist, die die Substrate in einer ersten Stellung hält und in einer zweiten freigibt. Die Erfindung betrifft weiterhin ein Verfahren zum Transportieren von Substraten.

Eine derartige Vorrichtung ist aus der auf dieselbe Anmelderin zurückgehende DE-A 44 13 077 bekannt. Eine Haube dient bei dieser Vorrichtung dazu, den Fluid-Behälter, in dem die Substrate behandelt werden, während des Prozeßvorgangs von oben abzudecken, und über diese Haube ein Fluid, etwa ein Gasgemisch, einzuleiten, das gemäß dem Marangoni-Prinzip das Trocknen der Wafer verbessert, die aus dem Fluidbad bewegt werden.

Auf der Oberseite des Fluid-Beckens ist, mit diesem fest verbunden, eine Halterungseinrichtung vorgesehen, die die Wafer nach dem Herausfahren aus dem Behandlungsfluid über der Fluidoberfläche halten. Zum Transport der Substrate aus dieser Stellung, beispielsweise zum Zurückstellen der Wafer in einen Waferträger, wird die Haube aufgeklappt, so daß ein Greifer die von den Halterungen gehaltenen Substrate ergreifen und in einen Substratträger umhorten kann. Das Beladen der Vorrichtung mittels des Greifers erfolgt in umgekehrter Reihenfolge. Danach wird die Haube wieder über die vom Greifer auf die Halterungen eingesetzten Substrate geschwenkt.

Obgleich die bekannte Vorrichtung mit gutem Erfolg arbeitet, weist sie dennoch Nachteile auf. Jede Umhortung mit einem zusätzlichen Greifer benötigt Zeit, die die Produktivität der Anlage beeinträchtigt. Jede Umhortung birgt grundsätzlich auch die Gefahr einer möglichen Beschädigung der Substrate. Darüber hinaus ist die Lage der Substrate auf den Halterungen nach dem Aufklappen bzw. vor dem Zuklappen der Haube labil, weil die Substrate lediglich auf der Unterseite in Schlitzen der Halterungen gehalten werden. Auch-sind für jedes Becken derartige Halterungen und die zur Verschiebung der Halterungen benötigten Antriebseinrichtungen erforderlich, wodurch der Herstellungs- und Wartungsaufwand hoch ist.

Aus der US-4 987 407 A und der US RE 33341 E ist jeweils eine Vorrichtung zum automatischen Handhaben von Wafern bekannt, bei der zwei kammförmige, drehbare Stäbe vorgesehen sind, die nach Anheben der Substrate unter sie greifen und sie halten, so daß eine Aufnahmekassette unter die Wafer gebracht werden kann, in die die Wafer dann nach Freigabe durch die kammartigen Stangen abgesenkt werden können. Die kammartigen Stangen bilden dabei die einzige Halterungsmöglichkeit für die Wafer mit der Folge, daß die Wafer aufgrund der zwei-Punkt-Halterung einer hohen mechanischen Beanspruchung ausgesetzt sind und die Gefahr von Brüchen im Bereich der kammartigen Stäbe besteht. Darüber hinaus sind die kammartigen Stäbe dieser bekannten Vorrichtung nur zum Haltern der Substrate für ein Umhorden und nicht in Zusammenhang mit einer Transportvorrichtung oder einer Haube vorgesehen, die Teil einer Vorrichtung zur Substratbehandlung ist.

Der Erfindung liegt daher die Aufgabe zugrunde, eine Vorrichtung zu schaffen und ein Verfahren anzugeben, die bzw. das mit einem geringen Herstellungs- und Wartungsaufwand auskommt, eine sichere Behandlung und Handhabung der Substrate ermöglicht, den Behandlungsvorgang der Substrate vereinfacht, und/oder mit kleinerem Behältervolumen und dadurch mit weniger Behandlungsfluid auskommt.

Die erfindungsgemäße Fluidbehandlungsvorrichtung weist den Vorteil auf, daß die Haltestange keinen Raum außerhalb der Substrat-Transportiereinrichtung benötigt, beispielsweise keine Greifarme, so daß der Raumbedarf für die erfindungsgemäße Vorrichtung wesentlich geringer ist als bei herkömmlichen Einrichtungen. Dies hat den Vorteil, daß das Behältervolumen der Fluid-Behälter wesentlich geringer sein kann, da raumbeanspruchende Greiferarme oder dergleichen nicht erforderlich sind. Darüber hinaus sind die Betätigungseinrichtungen für die erfindungsgemäße Haltestange bzw. zum Drehen derselben wesentlich einfacher sowohl hinsichtlich des Herstellungs- als auch des Wartungsaufwands und auch der Steuer- und Drehvorgang ist wesentlich zuverläßlicher und substratschonender als dies mit herkömmlichen Greiferarmen der Fall ist. Die Haltestange ist dabei vorteilhafterweise durch Drehung aus der ersten, die Substrate haltenden Stellung in eine zweite, die Substrate freigebende Stellung drehbar. Dadurch ergibt sich eine sehr einfaches Umstellung vom Halten der Substrate in die Freigabestellung und umgekehrt, was insbesondere auch zur Beschleunigung des Verfahrensablaufs und damit zur Erhöhung der Produktivität der Vorrichtung beiträgt.

Gemäß der Erfindung weist die Transporteinrichtung wenigstens zwei gegenüberliegende Wände mit Schlitzen für die Substrate auf. Die Schlitze dienen dabei der Führung und Halterung während des Einschiebens der Substrate in die Transporteinrichtung bei die Substrate freigebender Stellung der Haltestange und/oder zur Halterung der Substrate, wenn sie mit der Haltestange in der Transporteinrichtung gehalten werden.

Die Haltestange ist dabei in wenigstens einer Wand angeordnet und erstreckt sich über die Breite eines Substrat-Pakets, das von der Transporteinrichtung transportiert wird bzw. werden soll.

Gemäß der Erfindung ist die Transporteinrichtung eine Haube. Dadurch ergibt sich die Möglichkeit, die Substrate ohne Greifer lediglich dadurch in einen Substratträger zu bringen bzw. aus einem Substratträger zu holen, daß die gesamte Haube über den Substratträger gebracht wird, der sich etwa neben dem Fluid-Becken befindet. Da kein zusätzlicher Umhordungsprozeß mit einem eigenen Greifer erforderlich ist, können die Wafer wesentlich schneller umgehordet und es kann die Gefahr von Waferbeschädigungen verringert werden. Durch die Integration des Substrattransfers in der Haube ist es auch möglich, für mehrere Prozeßstationen bzw. Fluid-Becken nur eine Haube vorzusehen, da dieselbe Haube für mehrere Prozeßstationen dient, und die Substrate selbst mit transportiert. Es ist daher nicht mehr erforderlich, daß jede Prozeßstation bzw. jeder Fluid-Behälter eine Haube und/oder eigene Substrat-Halterungen oberhalb des Behälters aufweisen muß, um die Substrate - wie bei bekannten Vorrichtungen - einem Greifer zugänglich zu machen. Mit der erfindungsgemäßen Vorrichtung ist die Behandlung und Handhabung von Substraten wesentlich einfacher, sicherer und mit einem geringerem Herstellungs- und Wartungsaufwand möglich. Insbesondere auch die Größe des Fluid-Behälters und damit die Menge des üblicherweise sehr teuren Behandlungsfluids können wesentlich reduziert werden.

Die Haltestange weist wenigstens einen Bereich auf, der in der die Substrate haltenden ersten Stellung in den Innenraum der Transporteinrichtung bzw. der Haube vorsteht. Bei scheibenförmigen Substraten, beispielsweise bei Silizium-Wafern, befindet sich die Haltestange unterhalb einer Scheibenhälfte, wenn sich die Scheiben in der Haube befinden. Im Falle, daß rechteckförmige oder quadratische Substrate behandelt werden sollen, befindet sich die Substrat-Haltestange bei von der Transporteinrichtung oder Haube aufgenommenen Substraten unterhalb der Substratseitenkanten.

Die in Form einer Haltestange ausgebildete erfindungsgemäße Substrat-Halteeinrichtung erstreckt sich vorzugsweise über die gesamte Breite der die Halteeinrichtung aufnehmenden Seitenwand. Dies trifft auch für den in den Innenraum hineinragenden Bereich oder Vorsprung zu, so daß sämtliche nebeneinanderstehenden Substrate in der die Substrate haltenden, ersten Stellung auf der Substrat-Halteeinrichtung aufliegen und dadurch in der Transporteinrichtung oder Haube gehalten werden können.

Gemäß einer weiteren sehr vorteilhaften Ausgestaltung der Erfindung ist die drehbare Haltestange so ausgebildet, daß sie in der die Substrate freigebenden, zweiten Stellung mit der Seitenwand-Innenfläche abschließt. Die Haltestange weist also vorzugsweise eine ebene Fläche auf, die mit der Seitenwand-Innenfläche der Transporteinrichtung oder Haube eine einheitliche Wandfläche bildet, wenn die Haltestange sich in der Stellung befindet, in der die Substrate freigegeben sind.

Im freigegebenen Zustand der Substrate werden diese vorzugsweise von einer dem Fluid-Behälter zugeordneten Halterung, etwa einer messerartigen Leiste von unten gehalten und durch Absenken dieser Halterung in den Fluid-Behälter gebracht. Im Falle, daß die Haube dabei ebenfalls mit einem Fluid, beispielsweise einem Gas oder einem Gasgemisch beaufschlagt wird, wie dies etwa in Zusammenhang mit dem Trocknen von Wafern nach dem Marangoni-Prinzip vorgesehen ist, sollte die Haube nach außen dicht sein. Gemäß einer besonders vorteilhaften Ausgestaltung der Erfindung ist die Haltestange in der Seitenwand der Haube daher so angeordnet und angebracht, daß sie zumindest in ihrer zweiten, die Substrate freigebenden Stellung die Seitenwand nach außen abdichtet. Sollte dies nicht oder nur mit hohem Aufwand möglich sein, so besteht eine alternative Ausführungsform auch darin, die Substrat-Halteeinrichtung mittels eines Gehäuses nach außen abzuschließen.

Gemäß einer besonders vorteilhaften Ausführungsform der Erfindung weist die Haltestange einen im wesentlichen rechteckförmigen Querschnitt auf. In der die Substrate freigebenden, zweiten Stellung schließt dabei eine Rechteckfläche mit der Seitenwand-Innenfläche ab.

Gemäß einer weiteren sehr vorteilhaften Ausführungsform der Erfindung weist die Haltestange einen viereckigen, sechseckigen, achteckigen oder allgemein einen polygonen Querschnitt auf, so daß je nach den gegebenen Verhältnissen verschiedene Formen oder Ausbildungen des ins innere der Haube ragenden Teils der Haltestange für das Halten der Substrate in der ersten Stellung vorgesehen sind. Dadurch ist es möglich, mit derselben Haltestange unterschiedliche, an die jeweiligen Substrate, Substratdicken und/oder Substratabstände angepaßte Halteelemente mit einer einzigen Haltestange vorzusehen. Durch entsprechendes Drehen der Haltestange sind daher verschiedene Steg-Vorsprünge zum wahlweisen Halten der Substrate möglich. Dies ergibt sich auch bei einer im Querschnitt runden Haltestange, bei der wenigstens ein Kreissegment im Querschnitt entfernt ist.

Gemäß einer weiteren sehr vorteilhaften Ausgstaltung der Erfindung weist die Haltestange in den Längsbereichen, an denen die Substrate in der ersten, die Substrate haltenden Stellung anliegen, Schlitze für die Substrate auf. Dadurch ergibt sich für die Substrate ein sicherer Halt und der Abstand zwischen den Substraten wird dadurch sicher aufrechterhalten. Dabei ist es vorteilhaft, die zuvor beschriebenen, verschiedenen Steg-Vorsprünge, Bereiche und/oder polygonen Flächen der Haltestange mit Schlitzen zu versehen, die unterschiedlich Abstände, unterschiedliche Schlitzbreiten und/oder unterschiedliche Schlitztiefen für unterschiedlich dicke Substrate oder für Substrate mit unterschiedlicher Packungsdichte aufweisen.

Gemäß einer Ausführungsform der Erfindung entsprechen die Abschnitte zwischen den Schlitzen den Abständen zwischen den Substraten eines Substratpakets. Gemäß einer besonders vorteilhaften Ausgestaltung der Erfindung sind die Abstände zwischen den Schlitzen halb so groß wie die Abstände zwischen den Substraten eines Substratpakets, d.h. jeder zweite Schlitz der Haltestange bzw. des Steg-Vorsprungs, oder des ins Innere der Transporteinrichtung vorstehenden Bereichs und/oder der polygonen Fläche der Haltestange ist bei Einführen eines Substratpakets mit einem Substrat besetzt.

Ganz allgemein ist es erfindungsgesmäß auch möglich, die Abstände zwischen den Schlitzen als ganzzahligen Bruchteil zu den Abständen zwischen den Substraten eines Substratpakets zu wählen, so daß beispielsweise nur jeder dritte, vierte oder fünfte Schlitz mit einem Substrat eines eingebrachten Substratpakets besetzt ist.

Gemäß einer besonders vorteilhaften Ausgestaltung der Erfindung weist die Haltestange eine dritte Stellung auf, in der ein erster Teil des Substrats gehalten und ein zweiter Teil freigegeben ist. Vorzugsweise wird jeweils jedes zweite Substrat gehalten und jedes dazwischenliegende Substrat freigegen. Auf diese Weise ist es in der dritten Stellung der Haltestange, die durch Drehen der Haltestange eingenommen werden kann, möglich, einen ersten Teil der Substrate, etwa ein erstes bereits in die Transporteinrichtung eingebrachtes Substratpaket zu halten und einen zweiten Teil von Substraten, etwa ein zweites Substratpaket im freigegebenen Teil der Haltestange, an der sich die Schlitze zur Durchführung dieser Substrate befinden, zusätzlich und versetzt zum ersten Teil der Substrate bzw. des ersten Substratpakets in die Transporteinrichtung einzuführen. Wie im weiteren noch im einzelnen beschrieben werden wird, wird danach die Haltestange in die erste Stellung gebracht bzw. gedreht, in der sie dann alle Substrate sowohl des ersten als auch des nachfolgend eingebrachten zweiten Substratpakets hält. Auf diese Weise ist es mög-lich, das Substratpaket auf einfache Weise zu verdichten und zwei Substratpakete mit doppelten Subtratabständen zu einem Substratpaket mit einfachen Substratabständen, also ohne Lücke, zusammenzuführen.

Da die Substrat-Transporteinrichtung eine Haube ist, die auch bei dem Prozessieren der Substrate in einem Fluid-Behälter über dem Fluid-Behälter angeordnet ist, ist es vorteilhaft, wenn die Haltestange in ihrer ersten, zweiten und/oder dritten Stellung die Seitenwand der Transporteinrichtung bzw. der Haube nach außen abdichtet.

Gemäß einer weiteren vorteilhaften Ausführungsform der Erfindung ist die erfindungsgemäße Haube gleichzeitig eine Prozeßhaube, die beispielsweise das Fluid-Becken während des Behandlungsprozesses nach außen abschließt und deren Innenraum mit zur Behandlung der Substrate herangezogen wird. Sehr vorteilhaft ist es dabei, wenn die Haube Einlaßöffnungen zum Einlassen von wenigstens einem Fluid, beispielsweise einem Gas oder einem Gasgemisch aufweist. Derartige Verfahren und Vorrichtungen sind in den auf die Anmelderin der vorliegenden Anmeldung zurückgehenden nicht vorveröffentlichten DE-A 195 46 990 beschrieben.

Beispielsweise ist es vorteilhaft, in der Haube Einlaßöffnungen oder Diffuser zum Einlassen von Isopropyl-Alkohol oder einer Isopropyl-Alkohol enthaltenden Gasmischung vorzusehen, wenn die Haube für eine Trocknungsprozeß nach dem Marangoni-Verfahren eingesetzt wird.

Gemäß einer weiteren, vorteilhaften Ausführungsform der Erfindung weist die Haube eine Schließvorrichtung auf der dem Fluid-Behälter zugewandten Seite auf. Auf diese Weise ist es möglich, die in der Haube befindlichen Substrate beim Transport von einem Behandlungsprozeß zum anderen gegenüber dem Außenraum abzuschirmen, um zu verhindern, daß während des Transportes mit der Haube Verunreinigungen an dies Substrate gelangen können.
Gemäß einer sehr vorteilhaften Ausführungsform der Erfindung ist eine Substrat-Lade- und/oder Entladestation zum Be- und/oder Entladen der Transporteinrichtung vorgesehen. Die Lade- und/oder Entladestation für die Substrate ist dabei vorzugsweise neben den Fluid-Behältern angeordnet, so daß die Transporteinrichtung, vorzugsweise in Form einer Haube, von der Lade- und/oder Entladestation über den Fluid-Behälter, und umgekehrt, bringbar ist.

Vorzugsweise weist die Substrat-Lade- und/oder Entladestation einen unter die Transporteinrichtung schiebbaren Substratträger-Halter auf, so daß ein Substrate enthaltender Substratträger unter die Transporteinrichtung geschoben und von dort die Substrate in die Transporteinrichtung gebracht werden können, oder ein leerer Substratträger zur Aufnahme der Substrate aus der Transporteinrichtung beim Entladen in die Aufnahmestellung gebracht wird.

Gemäß einer besonders vorteilhaften Ausführungsform der Erfindung weist der Substratträger-Halter wenigstens zwei Verschiebestellungen auf, die in Richtung der Substratpaket-Achsen zueinander um einen halben Substratabstand versetzt sind. Auf diese Weise ist es möglich, zunächst ein Substratpaket in die Transporteinrichtung zu bringen, um dann ein weiteres Substratpaket, das zum ersten Substratpaket um einen halben Substratabstand versetzt ist, ebenfalls in die Transporteinrichtung zu bringen, und zwar dann, wenn die Haltestange in ihrer dritten Stellung ist, in der das erste Substratpaket gehalten ist und das zweite Substratpaket beispielsweise durch entsprechende durchgehende Schlitze in dem in die Transporteinrichtung vorstehenden Bereich der Haltestanges über diese hinweg zusätzlich in die Transporteinrichtung gebracht werden kann, so daß dadurch mit einfachen Mitteln und einer einfachen Vorgehensweise eine Verdichtung der Substrate in der Transporteinrichtung möglich wird. Auf diese Weise ist es möglich, pro Paketvolumen beispielsweise die doppelte Anzahl von Substraten in einem Fluid-Behälter zu behandeln, obgleich die Substrate in den Substratträgern mit doppelten Abstand zueinander angeordnet sind. Dies ermöglicht eine wesentlich höhere Produktivität hinsichtlich des Zeitaufwands und eine erhebliche Einsparung an Behandlungsfluid.

Vorzugsweise weist die Lade- und/oder Entladestation eine Substratanheb-Vorrichtung zum Anheben und Absenken der Substrate in die Transporteinrichtung bzw. aus der Transporteinrichtung auf. Eine derartige Substratanheb-Vorrichtung weist vorzugsweise wenigstens einen sich über die Breite des Substratpakets erstreckenden Steg auf, der zur Aufnahme oder sicheren Halterung der Substrate in Längsrichtung des Stegs bzw. der Stege Schlitze oder Einkerbungen aufweist. Eine drartige Substratanheb-Vorrichtung kann beispielsweises in gleicher oder ähnlicher Weise ausgeführt werden, wie dies für das Anheben und Absenken der Substrate aus einem oder in einen Fluid-Behälter in der DE-A-44 13 077 oder der zuvor genannten, nicht vorveröffentlichten deutschen Anmeldung derselben Anmelderin beschrieben ist.

Die Aufgabe der Erfindung wird auch durch ein Verfahren zum Transportieren von Substraten mit einer Vorrichtung nach einem der vorhergehenden Ansprüche dadurch gelöst, daß der Beladungsvorgang der Transporteinrichtung mit den Substraten folgende Verfahrensschritte aufweist:
a) Drehen der Haltestange in die die Substrate freigebenden zweite Stellung,
b) Einschieben der Substrate in die Transporteinrichtung bis sich wenigstens die breitesten Bereiche der Substrate über der Haltestange befinden und
c) Drehen der Haltestange in die erste, die Substrate haltende Stellung.
Das Entladen der Transporteinrichtung erfolgt in umgekehrter Weise, indem die Haltestange aus der ersten, die Substrate haltenden Stellung in die zweite, die Substrate freigebende Stellung gedreht und die Substrate dann aus der Transporteinrichtung gebracht werden. Zum Einschieben und Herausfahren der Substrate in die Transporteinrichtung bzw. aus der Transporteinrichtung ist vorzugsweise eine Halterungsvorrichtung in Form einer messerartigen Leiste vorgesehen, die auf- und abbewegbar ist. Eine derartige Halterungsvorrichtung sowie deren Antriebseinrichtung ist beispielsweise in der DE-A-44 13 077 oder der zuvor genannten, nicht vorveröffentlichten deutschen Anmeldung derselben Anmelderin beschrieben.

Gemäß einer besonders vorteilhaften Ausführungsform des erfindungsgemäßen Verfahrens für die Substratverdichtung in der Transporteinrichtung sind folgende Verfahrensschritte nacheinander vorgesehen:
a) Drehen der Haltestange in die die Substrate freigebende zweite Stellung,
b) Einschieben eines ersten Substratpakets in die Transporteinrichtung, bis sich wenigstens die breitesten Bereiche der Substrate über der Haltestange befinden,
c) Drehen der Haltestange in die dritte Stellung, in der das eingeschobene Substratpaket von der Haltestange gehalten wird,
d) Einschieben eines zweiten Substratpakets, das in seiner Lage bezüglich des ersten Substratpakets um einen halben Substrat-Abstand in Längsrichtung der Haltestange versetzt ist und
e) Drehen der Haltestange in die zweite Stellung, in der alle Substrate gehalten werden.

Auf diese Weise ist es möglich, das Substratpaket, welches in einem Substrathalter mit normalem Abstand zwischen den Substraten liegen, zu einem Substratpaket mit doppelter Substratdichte zu verdichten. Bei einem Substrathalter mit zum Beispiel 25 Wafern kann daher durch das Zusammenfügen von zwei Substratpaketen mit normaler Beabstandung nur ein Substratpaket mit einer doppelten Dichte der Substrate, nämlich mit 50 Substraten auf einfache Weise, sicher und zuverlässig gebildet werden, so daß bei der Behandlung des Halb-Abstand-Substratpakets gegenüber einem Normal-Abstand-Substratpaket bei der Behandlung in den Fluid-Behältern eine wesentlich größere Produktivität und die Verwendung wesentlich geringerer Fluidmengen möglich ist.

Das Entladen der Transporteinrichtung läuft in umgekehrter Reihenfolge ab, in dem die Haltestange aus der zweiten, alle Substrate erhaltenden Stellung in die dritte Stellung gedreht wird, bei der jedes zweite Substrat von der Haltestange freigegeben und etwa durch Absenken der Haltevorrichtung entladen wird. Nach dem Entladen des ersten Substratpakets wird die Haltestange aus der dritten Stellung in die zweite Stellung gedreht, in der auch das zweite, noch in der Transporteinrichtung befindliche Substratpaket freigegeben wird.

Besonders vorteilhaft ist es, wenn am Ende des Verfahrensschrittes d) sowohl das erste als auch das zweite Substratpaket so weit angehoben werden, daß während des Drehens der Haltestange gemäß Verfahrensschritt e) in die zweite Stellung, in der alle Substrate gehalten werden, keine Substrate auf der Haltestange aufliegen. Auf diese Weise entsteht beim Drehen der Haltestange kein Abrieb an den Substraten und/oder an der Haltetange, so daß die Entstehung von Partikeln insofern nicht möglich ist.

Mit der Erfindung ist es auch möglich, ein verdichtetes Substratpaket zu schaffen, das aus mehr als zwei Ausgangs-Substratpaketen besteht.

Die Erfindung wird nachfolgend anhand bevorzugter Ausführungsbeispiele unter Bezugnahme auf die Zeichnungen näher erläutert. Es zeigen:
- Fig. 1: Eine Ausführungsform der erfindungsgemäßen Vorrichtung mit einer Substrat-Halteeinrichtung in Form einer Haltestange, die sich in einer die Substrate in einer Haube haltenden Stellung befindet,
- Fig. 2: die in Fig. 1 dargestellte Ausführungsform, bei der sich die Haltestange in der die Substrate freigebenden Stellung befindet,
- Fig. 3: eine weitere Ausführungsform der erfindungsgemäßen Vorrichtung in Blickrichtung von oben auf die Haltestange,
- Fig. 4: eine Querschnittsdarstellung entlang der in Fig. 3 eingezeichneten Schnittlinie IV-IV,
- Fig. 5: eine Querschnittsdarstellung entlang der in Fig. 4 eingezeichneten Schnittlinie V-V;
- Fig. 6: eine Darstellung der Vorrichtung gemäß den Fig. 3 bis 5 in Blickrichtung VI mit Darstellung der hydraulischen Antriebsvorrichtung für die Haltestange,
- Fig. 7: eine vergrößerte Darstellung der Haltestange in Blickrichtung von oben auf die Haltestange,
- Fig. 8: eine Querschnittsdarstellung der Haltestange entlang der in Fig. 7 eingezeichneten Schnittlinie VIII-VIII,
- Fig. 9: eine Querschnittsdarstellung der in Fig. 7 eingezeichneten Schnittlinie IX-IX und
- Fig.10: eine schematische Darstellung der erfindungsgemäßen Vorrichtung mit einer Substrat-Lade- und/oder Entladestation zum Be- und/oder Entladen der Transporteinrichtung.

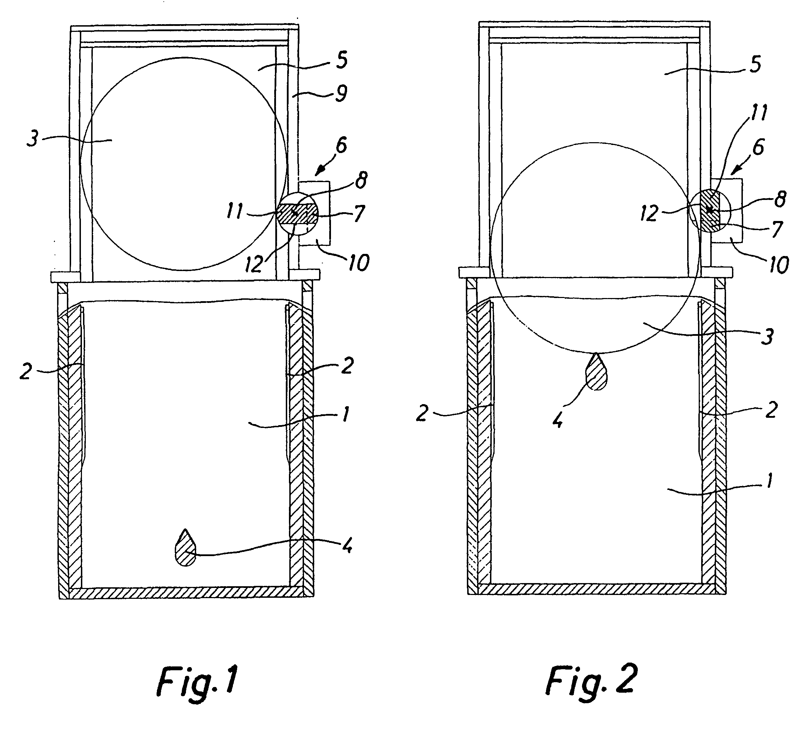

Die Ausführungsform gemäß Fig. 1 und 2 umfaßt einen Fluid-Behälter 1 mit Halteschlitzen 2 für die einzusetzenden Substrate 3 sowie einer Halterungsvorrichtung 4 in Form einer messerartigen Leiste, mit denen die Substrate 3 in den Fluid-Behälter 1 abgesenkt oder aus ihm herausgehoben werden (vgl. Fig. 2).

Über dem Fluid-Behälter 2 befindet sich Transporteinrichtung in Form einer Haube 5, an deren einen Seitenwand 9 eine Substrat-Halteeinrichtung 6 vorgesehen ist. Bei der dargestellten Ausführungsform der Substrat-Halteeinrichtung 6 ist eine im wesentlichen im Querschnitt rechteckförmige Haltestange 7 vorgesehen, die um eine Achse 8 drehbar ist. Die Haltestange 7 ist in einer Seitenwand 9 der Haube 5 angeordnet und erstreckt sich im wesentliche über die gesamte Breite dieser Sietenwand 9. Ein Gehäuse 10 schließt den Bereich der Seitenwand 9, an dem sich die Substrat-Halteeirichtung 6 befindet, nach außen ab.

In Fig. 1 ist die Substrat-Haltevorrichtung 6 in einer ersten, die Substrate 3 haltenden Stellung gezeigt. Die im Querschnitt im wesentlichen rechteckförmige Stange 7 befindet sich in einer Drehlage, in der ein Bereich bzw. Steg-Vorsprung 11 in den Innenraum der Haube 5 ragt und die Substrate 3 in der Haube 5 hält.

Fig. 2 zeigt die Substrat-Halteeinrichtung in der die Wafer freigebenden zweiten Stellung. Die um die Achse 8 drehbare Stange 7 wurde gegenüber der Stellung in Fig. 1 um 90° im Uhrzeigersinn gedreht, so daß der Steg-Vorsprung 11 nicht mehr in den Innenraum der Haube 5 ragt. Vielmehr schließt nunmehr eine lange Seite 12 der im Querschnitt rechteckförmigen Stange 7 mit der Innenfläche der Seitenwand 9 ab, so daß die Wafer 3 nach unten gleiten und auf der Halterungsvorrichtung 4 des Fluid-Behälters 1 in dieses abgesenkt werden können.

Wie aus Fig. 2 ersichtlich ist, weisen die Ausschnittsflächen der Seitenwand 9, bezüglich der Außenflächen der Haltestange 7, die den Ausschnittsflächen der Seitenwand 9 in dieser Stellung gegenüber liegen, eine komplementäre Form auf und schließen dadurch die für die Haltestange 7 vorgesehen Öffnung in der Seitenwand 9 nach außen ab, insbesondere dann, wenn sich die Substrat-Halteeinrichtung in der in Fig. 2 gezeigten, die Substrate freigebenden Stellung befindet.

Die Bereiche der Haltestange 7, die in der ersten, in Fig. 1 dargestellten Stellung mit den Wafern in Berührung kommen und diese in der Haube 5 halten, sind vorzugsweise mit Schlitzen zum sicheren Halt und zur Fixierung eines definierten Abstands zwischen den Wafern 3 versehen.

In dem in Fig. 1 dargestellten Zustand sind die Substrate 3 durch die Substrat-Halteeinrichtung 8 und die in der Haube 5 vorgesehenen Halteschlitze 15 in ihrer Lage sicher gehalten, so daß die gesamte Haube 5 zusammen mit den Substraten 3 an einen anderen Ort, beispielsweise über einen weiteren Fluid-Behälter oder über einen leeren Substratträger gebracht werden können, ohne daß eine weitere Hordung etwa mittels eines Greifers erforderlich ist. Dieselbe Haube 5 kann daher sowohl als Prozeßhaube als auch als Transporteinrichtung verwendet werden. Durch eine relative Horizontalbewegung zwischen der Haube 5 und einer Substratanhebe-Vorrichtung werden die in der Haube 5 befindlichen Substrate 3 über den Substratträger gebracht und in ihn abgesetzt. Die Substrat-Halteeinrichtung 6 wird durch Drehen der Haltestange 7 geöffnet und durch eine weitere Relativbewegung der Substrate 3 zwischen der Haube 5 und dem Substratträger bzw. dem Substrat-Messer werden die Substrate 3 auf einfache Weise umgehordet. In entsprechender Weise werden die Substrate aus einem Subtratträger in die Haube 5 umgehordet, wobei nach Umhordung dann die Substrat-Halteeinrichtung 6 wieder in die Fig. 1 dargestellte, die Substrate 3 haltende Stellung gebracht wird.

Es ist möglich, nicht nur an einer, sondern an beiden Seitenwänden 9, 13 der Haube 5 jeweils eine Substrat-Halteeinrichtung 6 vorzusehen. Auch ist es möglich, die in den Fig. 1 und 2 gezeigte Haltestange 7 der Substrat-Halteeinrichtung 6 mit einer anderen Querschnittsform auszubilden. Statt drehbaren Stangen ist es auch möglich, für die Substrat-Halteeinrichtung 6 wenigstens eine Klappe vorzusehen, die aus der Seitenwand 9 der Haube 5 wahlweise nach innen ausklappbar ist.

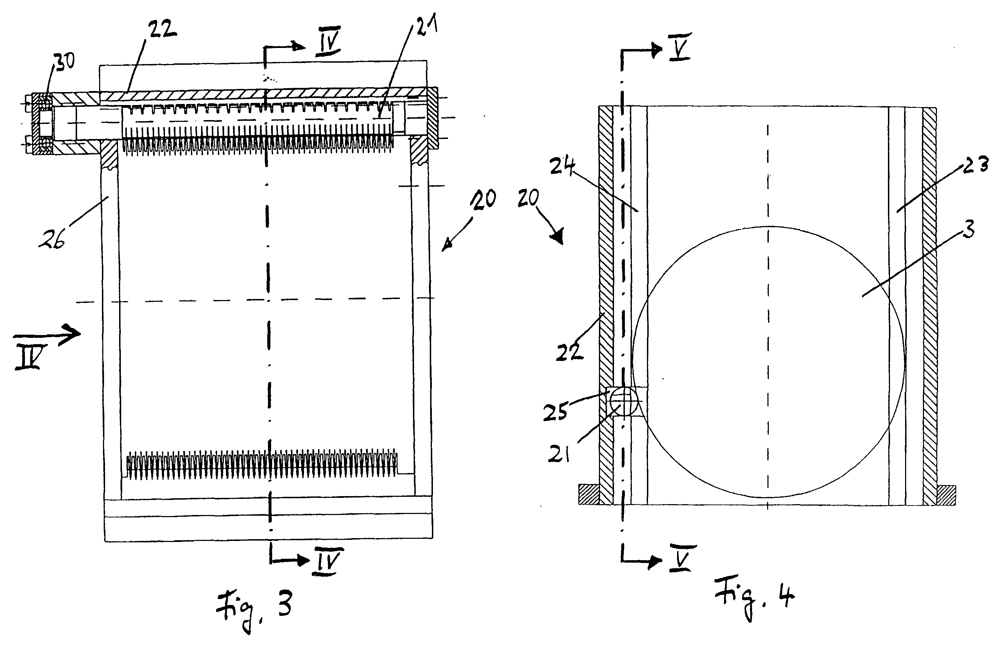

Die Fig. 3 bis 6 zeigen Darstellungen und Querschnitte einer weiteren Ausführungsform der erfindungsgemäßen Vorrichtung mit einer Transporteinrichtung in Form einer Haube 20. Wie insbesondere aus Fig. 4 ersichtlich ist, befindet sich die eine andere als in den Fig. 1 und 2 dargestellte Ausführungsform aufweisende Haltestange 21 innerhalb der die Haltestange 21 tragenden Seitenwand 22, so daß Dichtungsschwierigkeiten an dieser Stelle nicht auftreten. Die Substrate 3 werden dabei durch mit Schlitze versehenen Bandelementen 23, 24 gehalten, wobei im Element 24 eine Ausnehmung 25 für die Haltestange 21 vorgesehen ist.

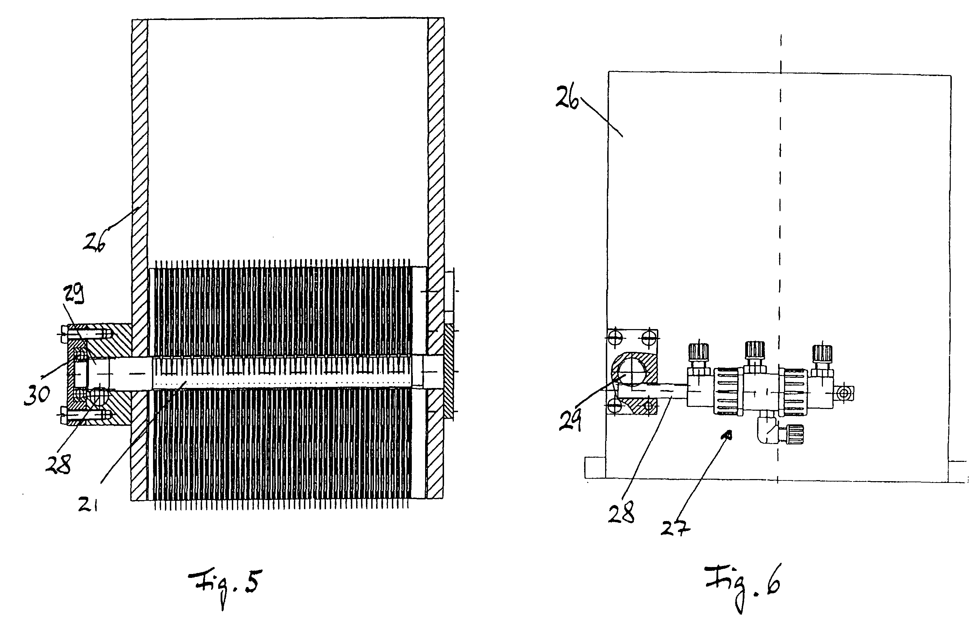

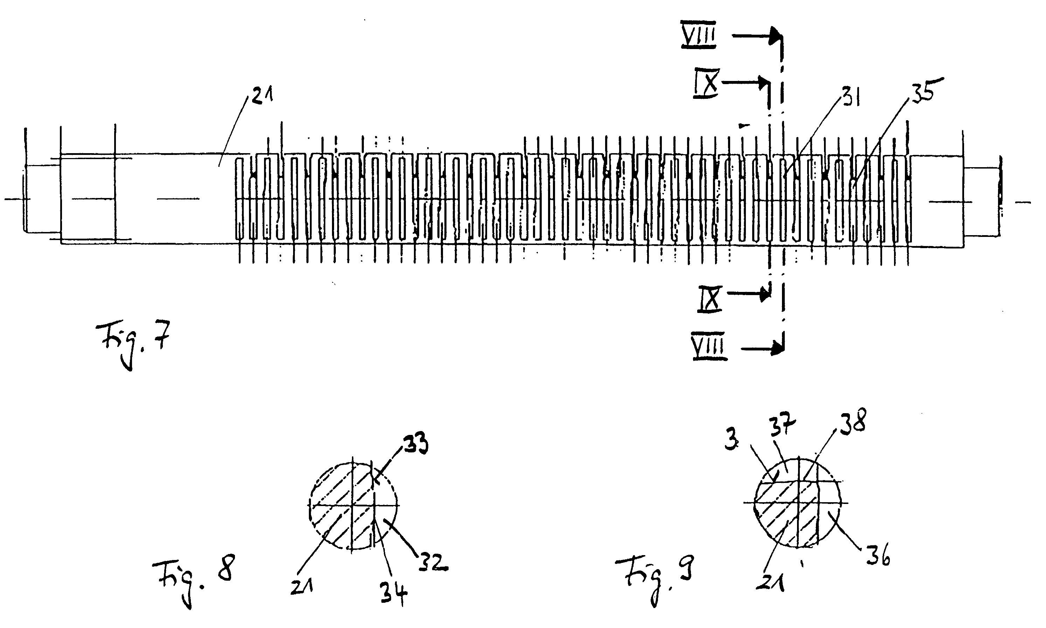

Wie aus den Fig. 3 und 5 und insbesondere aus Fig. 6 ersichtlich ist, befindet sich auf der Außenseite einer Wand 26 der Haube 20 eine Antriebseinrichtung 27, die im dargestellten Ausführungsbeispiel hydraulisch betätigt wird, einen Doppelzylinder aufweist und drei Schaltstellungen besitzt, die im nachfolgenden insbesondere anhand der Fig. 7, 8 und 9 noch im einzelnen beschrieben werden. Eine Antriebsstange 28, die durch die hydraulische Antriebseinrichtung 27 nach rechts und links verschoben wird, ist als Zahnstange ausgebildet und dreht eine Welle 29 der Haltestange 21.

Die Antriebseinrichtung zum Drehen der Haltestange 21 kann in unterschiedlichen Ausführungsformen, beispielsweise mit einem Linearmotor realisiert werden, wobei die Antriebseinrichtung 27 mit einem Doppelzylinder jedoch eine besonders einfache und zuverlässiges Ausführungsform darstellt, weil drei Schaltstellungen ohne weitere Regelung oder Wegabfragen auf einfache Weise und zuverlässig eingenommen werden, und bei Vorrichtungen dieser Art ohnehin Hydraulikeinrichtungen vorhanden sind.

Zur Abdichtung des Inneren der Haube 20 nach außen sind an den Endbereichen der Welle 29 Dichtungselemente, etwa Dichtungsringe 30 vorgesehen.

In Fig. 7 ist die Haltestange 21 des Ausführungsbeispiels gemäß den Fig. 3 bis 6 in vergrößertem Maßstab dargestellt, wobei sich die Seitenwand 22, an bzw. in der die Haltestange 21 angeordnet ist, in Fig. 7 auf der unteren Längsseite befindet, und die Haltestange 21 in Blickrichtung von oben, also parallel zu den Substratebenen gesehen wird. Die obere Längsseite der Haltestange 21 in Fig. 7 ist dem Inneren der Transporteinrichtung bzw. Haube 20 zugewandt.

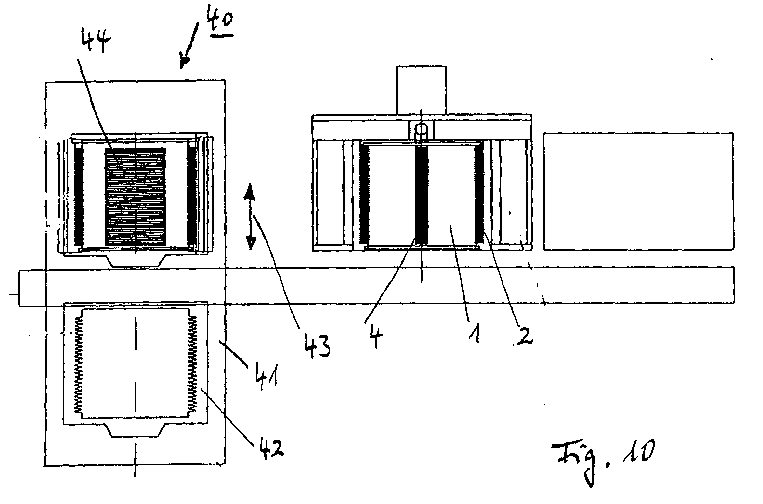

Bei der in den Fig. 7 bis 9 dargestellten Ausführungsform einer Haltestange 21 sind in Achsenrichtung jeweils abwechselnd zwei unterschiedliche Ausführungsformen von Schlitzen oder Einschnitten vorgesehen, deren Querschnitte aus den Fig. 8 und 9 ersichtlich sind.

Im Schnittbereich VIII-VIII der Fig. 7 ist ein Schlitz 31 in die Haltestange 21 eingeschnitten oder eingefräst, dessen Breite so gewählt ist, daß ein Substrat 3 hindurchgleiten kann, und dessen Querschnittsfläche einem Kreissegment 32 entspricht, wie dies in Fig. 8 dargestellt ist. Bei der in Fig. 7 und 8 dargestellten Drehstellung der Haltestange 21 liegen Randbereiche der Substrate 3 auf den dem Innenraum der Haube 20 zugewandten Abschnitten 33 der Schlitzböden auf und werden dadurch von der Haltestange 21 in ihrer Lage gehalten.

Bei Drehen der Haltestange 21 im Gegenuhrzeigersinn gelangen die Schlitze 31 in eine Stellung, bei der die Schlitzböden 34 bzw. die Abschnitte 33 der Schlitzböden 34 die Substrate 3 nicht mehr halten, so daß diese durch die Schlitze 31 nach unten gleiten können, oder Substrate 3 von unten durch die Schlitze 31 in dieser Stellung über die Haltestange 21 nach oben in die Transporteinrichtung gebracht werden können. Nach dem Beladen der Transporteinrichtung 20 mit Substraten 3 wird die Haltestange 21 um etwa 90° im Uhrzeigersinn in die in Fig. 7 dargestellte Stellung gedreht, so daß die eingebrachten Substrate 3 in der Transporteinrichtung gehalten werden.

Gemäß einer besonders vorteilhaften Ausführungsform der Erfindung befinden sich zwischen den anhand von Fig. 8 beschriebenen Schlitzen 31 jeweils Schlitze 35 mit Formen, die nachfolgend anhand von Fig. 7 und 9 erläutert werden, wobei Fig. 9 eine Querschnittsdarstellung entlang der in Fig. 7 eingezeichneten Schnittlinie IX-IX wiedergibt.

Der Schlitz 35 im Querschnittsbereich IX-IX weist ein Schlitzsegment 36 auf, das dem Kreis- oder Schlitzsegment 32 des Schlitzes 31 im Querschnittsbereich VIII-VIII entspricht. Darüber hinaus weist der Schlitz 35 jedoch ein weiteres Schlitzsegment 37 auf, das bezüglich des Schlitzsegments 36 um 90° gedreht ausgebildet ist. Bei dem in Fig. 9 dargestellten Querschnitt werden also die Substrate 3, die sich in den Schlitzen 35 befinden, nicht gehalten und können aus der Transporteinrichtung 20 entfernt bzw. in die Transporteinrichtung 20 eingeschoben werden. Dies bedeutet, daß die Substrate 3, die sich im Schlitz 31 befinden, von der Haltestange 21 gehalten, und die Substrate 3, die sich im Schlitz 35 befinden, freigegeben werden.

Bei Drehung der Haltestange 21 aus der in den Fig. 8 und 9 dargetellten Drehstellung um 90° im Gegenuhrzeigersinn befinden sich sowohl die Schlitze 31 als auch die Schlitze 35 in einer Stellung, in der sämtliche Substrate 3 freigegeben sind.

Bei Drehung der Haltestange 21 aus der in Fig. 8 und 9 dargestellten Drehstellung um 90° im Uhrzeigersinn werden auch die Substrate, die sich im Querschnittsbereich IX-IX oberhalb der Haltestange 21 befinden, vom Schliltzboden 38 bzw. vom Abschnitt 39 des Schlitzbodens 38 des Schlitzes 35 gehalten, so daß sowohl die Substrate im Querschnittsbereich VIII-VIII als auch im Querschnittsbereich IX-IX von der Haltestange 21 gehalten werden.

Die Funktionsweise der erfindungsgemmäßen Vorrichtung mit der in den Fig. 7 bis 9 dargestellten Haltestange 21 ist folgende:
Bei einer Drehstellung der Haltestange 21, die gegenüber der in den Fig. 7 bis 9 dargestellten Drehstellung um 90° im Gegenuhrzeigersinn gedreht ist, wird zunächst ein Substratpaket mit Substratabständen, die den Abständen der Schlitze 31 entsprechen, durch die Schlitze 31 über die Haltestange 21 eingeschoben. Danach wird die Haltestange 21 um 90° im Uhrzeigersinn gedreht. In dieser Stellung wird ein zweites Substratpaket, dessen Substrat 3 denselben Abstand wie die Substrate des ersten Substratpakets aufweisen, jedoch um einen halben Substratabstand dazu versetzt sind, in die Schlitze 35 eingeschoben. Dies ist möglich, weil das Segment 37 des Schlitzes 35 in dieser Stellung der Haltestange 21 die Substrate durchläßt.

Nachdem das zweite, gegenüber dem ersten um einen halben Substratabstand versetzte Substratpaket durch die Segmente 37 des Schlitzes 35 über die Haltestange 21 in die Transportvorrichtung eingeschoben ist, wird eine nicht dargestellte Substratanheb-Vorrichtung, die beispielsweise ein messerartiger Steg sein kann und etwa in der DE-44 13 077 derselben Anmelderin beschrieben ist, noch etwas weiter angehoben, so daß auch die im Schlitz 31 bereits gehaltenen Substrate 3 des ersten Substratpakets nochmals etwas angehoben werden und von der Haltestange 21 freikommen. Erst danach wird die Haltestange 21 nochmals um 90° im Uhrzeigersinn gedreht, so daß die Substrate 3 sowohl des ersten als auch des zweiten Substratpakets von der Haltestange 21 gehalten werden. Da die Substrate beider Pakete beim Drehen der Haltestange 21 nicht mehr auf ihr Aufliegen, wird ein Abrieb an den Substraten oder an der Haltestange 21 bei dessen Drehung vermieden.

Durch die Ausführungsform der Haltestange 21 gemäß den Fig. 7 bis 9 ist es also möglich, auf einfache Weise Substratpakete zu verdichten und beispielsweise Substratpakete mit normalem Abstand zu Substratpaketen mit halbem Abstand zuverlässich und ohne die Gefahr einer Berührung der Substrate untereinander auf einfache Weise zusammenzuführen. Dadurch können zwei Substratpakete mit normalem Substratabstand gleichzeitig in einem Fluid-Behälter behandelt werden, so daß sich erhebliche Produktiongssteigerungen ergeben und große Mengen an Behandlungsfluid eingespart werden können.

Das Entladen der Transporteinrichtunmg kann entweder in einem Vorgang, oder schrittweise unter Bildung von wiederum zwei Substratpaketen mit doppeltem Abstand der Substrate 3 untereinander erfolgen. Sollen alle Substrate 3, die sich sowohl in den Schlitzen 31 als auch in den Schlitzen 35 befinden, gleichzeitig aus der Transportvorrichtung ausgebracht werden, wird die Haltestange 21 in eine Drehstellung gebracht, wie sie durch Drehen der Haltestange 21 aus der in den Fig. 7 bis 9 dargestellten Stellung um 90° im Gegenuhrzeigersinn ergibt. Sollen die beiden Substratpakete jedoch getrennt ausgebracht werden, wird die Haltestange 21 zunächst in die in den Fig. 7 bis 9 dargestellte Drehstellung gebracht und erst dann um 90° im Gegenuhrzeigersinn gedreht, so daß auch die Substrate 3, die sich in den Schlitzen 31 befinden, entladen werden können.

In Fig. 10 ist eine schematische Darstellung eines Ausführungsbeispiels der erfindungsgemäßen Vorrichtung in Aufsicht wiedergegeben, bei der neben einem Fluid-Behälter 1 mit Führungsschlitzen 2 in den Seitenwänden und einer Halterungsvorrichtung, beispielsweise einem Substrat-messer 4, eine Be- und Entladestation 40 vorgesehen ist, die einen Substratträger-Halter 41 aufweist, der wie eine Schublade in Richtung des Doppelpfeils 43 verschiebbar ist und einen Substratträger 42 unter die anhand der Fig. 1 bis 9 beschriebenen Transporteinrichtung, beispielsweise eine Transporthaube 5, 20 bringen. Der Substratträger-Halter 41 weist dabei vorzugsweise zwei Verschiebestellungen für die Lage der Transportträger unterhalb der Transportvorrichtung auf, die sich voneinander um einen halben Abstand, mit denen die Substrate im Substratträger 42 stehen, unterscheiden. Dadurch ist es auf einfache Weise möglich, zwei normale Substratabstände aufweisende Substratpakete um einen halben Substratabstand versetzt unter die Transportvorrichtung zu bringen, um dadurch eine Verdichtung des Substratpakets in der Transportvorrichtung mit halbem Substratabstand zu erreichen, wie dies im Zusammenhang mit den Fig. 7 bis 9 im einzelnen beschrieben ist.

In Fig. 10 ist eine Substratanheb-Vorrichtung, ein sogenannter Pusher, mit dem Bezugszeichen 44 versehen, um die Substrate in der Lade- und/oder Entladestation 40 in die in Fig. 10 nicht dargestellte Transportvorrichtung zu schieben.

Nach dem Beladen der Transportvorrichtung bzw. der Haube 5 wird diese in der durch den Pfeil 45 angedeuteten Richtung über den Fluid-Behälter 1 gebracht und gegebenenfalls dort zur Abdichtung auf diesen abgesenkt. Danach wird die Halterungsvorrichtung 4, beispielsweise ein Substratmesser, aus dem Fluidbehälter 1 nach oben unter die in der Transporteinrichtung gehaltenen Substrate 3 gebracht, das sie dann übernimmt, wenn die Haltestange 7 bzw. 21 die Substrate freigibt.

Die Erfindung wurde zuvor anhand bevorzugter Ausführungsbeispiele beschrieben. Dem Fachmann sind jedoch Ausgestaltungen und Abwandlungen möglich. Obgleich die Erfindung anhand von Ausführungsbeispielen zur Verdichtung von zwei Substratpaketen zu einem Substratpaket erläutert wurde, ist die erfindungsgemäße Vorrichtung auch zur Verdichtung von mehr als zwei Paketen zu einem Paket geeignet. Zu diesem Zwecke kann die Haltestange 7 bzw. 21 mit entsprechenden Bereichen von Schlitzen und Schlitzform-Wiederholungen in Achsenrichtung ausgestattet werden, und die Be- und Entladestation 40 kann mehrere Verschiebestellungen aufweisen, die in Richtung der Substratpaketachse zueinander um beispielsweise ein Drittel oder ein Viertel der Substratabstände der zu verdichtenden Substratpakete versetzt sind.

## Patentansprüche

1. Vorrichtung zum Behandeln von Substraten (3) in einem Fluid-Behälter (1), mit einer über den Fluid-Behälter (1) bringbaren, als prozeßhaube ausgebildeten Substrat-Transporteinrichtung (5; 20), die wenigstens eine sich über die Breite eines Substrat-Pakets erstreckende, drehbare Haltestange (7, 21) aufweist, die durch Drehen aus einer ersten, die Substrate (3) haltenden Stellung in eine zweite, die Substrate 3 freigebende Stellung bringbar ist, wobei die Haltestange (7, 12) in wenigstens einer Wand (9 bzw. 22) der Transporteinrichtung (5, 20) angeordnet ist, und zwei gegenüberliegende Wände (8, 9 bzw. 22) der Transporteinrichtung (5, 20) Schlitze (23) für die Substrate (3) aufweisen, und wobei in der ersten Stellung der Haltestange (7, 21) Kantenbereiche der Substrate (3) aufliegen und die Substrate (3) i.n der zweiten Stellung aus der oder in die Transporteinrichtung (5, 20) bringbar sind.

2. Vorrichtung nach Anspruch 1, **dadurch gekennzeichnet, daß** die Haltestange (7, 21) wenigstens einen Bereich (11) aufweist, der in der die Substrate (3) haltenden, ersten Stellung in den Innenraum der Transporteinrichtung (5, 20) vorsteht.

3. Vorrichtung nach einem der vorhergehenden Ansprüche, **dadurch gekennzeichnet, daß** die Haltestange (7, 21) in der die Substrate (3) freigebenden, zweiten Stellung mit der Innenfläche der Wand (9, 22) der Transporteinrichtung (5, 20) abschließt.

4. Vorrichtung nach einem der vorhergehenden Ansprüche, **dadurch gekennzeichnet, daß** die Haltestange (7, 21) wenigstens zwei verschiedene Vorsprünge aufweist.

5. Vorrichtung nach einem der vorhergehenden Ansprüche, **dadurch gekennzeichnet, daß** die Haltestange (7, 21) einen im wesentlichen rechteckförmigen Querschnitt aufweist

6. Vorrichtung nach einem der vorhergehenden Ansprüche, **dadurch gekennzeichnet, daß** die Haltestange (7, 21) einen polygonen Querschnitt aufweist.

7. Vorrichtung nach einem der vorhergehenden Ansprüche, **dadurch gekennzeichnet, daß** die Haltestange (7, 21) in dem Längsbereich, an dem die Substrate (3) in der ersten, die Substrate haltenden Stellung anliegen, Schlitze (31, 35) für die Substrate (3) aufweist.

8. Vorrichtung nach Anspruch 4 oder 6, **dadurch gekennzeichnet, daß** die Vorsprünge (11) und/oder Polygonflächen Schlitze (31, 35) mit unterschiedlichen Abständen aufweisen.

9. Vorrichtung nach Anspruch 7 oder 8, **dadurch gekennzeichnet, daß** die Abstände zwischen den Schlitzen (31, 35) der Haltestange den Abständen zwischen den Substraten (3) eines Substratpakets entsprechen.

10. Vorrichtung nach Anspruch 7 oder 8, **dadurch gekennzeichnet, daß** die Abstände zwischen den Schlitzen (31, 35) der Haltestange halb so groß wie die Abstände zwischen den Substraten eines zu transportierenden Substratpakets sind.

11. Vorrichtung nach einem der vorhergehenden Ansprüche, **dadurch gekennzeichnet, daß** die Haltestange (7, 21) eine dritte Stellung aufweist, in der ein erster Teil der Substrate (3) gehalten und ein zweiter Teil freigegeben ist.

12. Vorrichtung nach Anspruch 11, **dadurch gekennzeichnet, daß** jeweils jedes zweite Substrat (3) gehalten und jedes dazwischenliegendes Substrat freigebbar ist.

13. Vorrichtung nach einem der vorhergehenden Ansprüche, **dadurch gekennzeichnet, daß** die Haltestange (7, 21) in ihrer ersten, zweiten und/oder dritten Stellung die Wand (9) nach außen abdichtet.

14. Vorrichtung nach einem der vorhergehenden Ansprüche **dadurch gekennzeichnet, daß** die Transporteinrichtung (5, 20) Einlaßöffnungen für wenigstens ein Fluid aufweist.

15. Vorrichtung nach einem der vorhergehenden Ansprüche, dadurch ekennzeichnet daß die Transporteinrichtung (5, 20) für einen Trocknungsprozeß nach dem Marangoni-Verfahren vorgesehen ist.

16. Vorrichtung nach einem der vorhergehenden Ansprüche, dadurch gekennzcichnet, daß die Transporteinrichtung (5, 20) eine Schließvorrichtung auf der dem Fluid-Behälter (1) zugewandten Seite umfaßt.

17. Vorrichtung nach einem der vorhergehenden Ansprüche, **gekennzeichnet durch** eine Lade- und/oder Entladestation (40) zum Be- und/oder Entladen der Prozeßhaube (5, 20).

18. Vorrichtung nach Anspruch 17, **gekennzeichnet durch** einen unter die Transporteinrichtung (5, 20) bringbaren Substratträger-Halter (41).

19. Vorrichtung nach Anspruch 18, **dadurch gekennzeichnet, daß** der substratträger-Halter (41) wenigstens zwei Verschiebestellungen aufweist, die in Richtung der Substratpaket-Achse zueinander um einen halben Substratabstand versetzt sind.

20. Vorrichtung nach einem der Ansprüche 17 bis 19, **dadurch gekennzeichnet, daß** die Lade- und/oder Entladestation (40) eine Substratanheb-vorrichtung (44) zum Anheben und/oder Absenken der Substrate (3) in die Transporteinrichtung (5, 20) bzw. aus der Transporteinrichtung (5, 20) aufweist.

21. Vorrichtung nach Anspruch 20, **dadurch gekennzeichnet, daß** die Substratanhcb-Vorrichtung (44) wenigstens ein sich über dic Breite des Substratpakets erstreckender Steg ist.

22. Vorrichtung nach Anspruch 20 oder 21, **dadurch gekennzeichnet, daß** die Substratanheb-Vorrichtung (44) an ihren Auflageflächen oder -kanten Schlitze oder Einkerbungen aufweist, deren Abstände halb so groß wie die Abstände der Substrate in dem Substratträger sind.

23. Verfahren zum Transportieren von Substraten mit einer Vorrichtung nach einem der vorhergehenden Ansprüche, **dadurch gekennzeichnet, daß** der Vorgang zur Beladung der Transporteinrichtung (5) mit den Substraten (3) folgende verfahrensschritte anfweist:
a) Drehen der Haltestange in die die Substrate (3) freigebende zweite Stellung,
b) Einschieben der Substrate in die Transporteinrichtung (5, 20) bis sich wenigstens die breitesten Bereiche der Substrate (3) über der Haltestange (7, 21) befinden, und
c) Drehen der Haltestange (7, 21) in die erste, die Substrate (3) haltende Stellung.

24. Verfahren nach Anspruch 23, **dadurch gekennzeichnet, daß** der Vorgang zur Beladung der Transporteinrichtung (5) mit den Substraten (3) folgende Verfahrensschritte aufweist:
a) Drehen der Haltestange (7, 21) in die die Substrate (3) freigebenden zweite Stellung,
b) Einschieben der Substrate (3) eines ersten Substratpakets in die Transporteinrichtung (5, .20), bis sich wenigstens die breitesten Bereiche der Substrate (3) über der Haltestange (7, 21) befinden,
c) Drehen der Haltestange (7, 21) in die dritte Stellung, in der das eingeschobene Substratpaket von der Haltestange (7, 21) gehalten wird,
d) Einschieben eines zweiten Substratpakets, das in seiner Lage bezüglich des ersten Substratpakets um einen halben Substrat-Abstand in Längsrichtung der Haltestange (7, 21) versetzt ist, und
e) Drehen der Haltestange (7, 21) in die zweite Stellung, in der alle Substrate gehalten werden.

25. Verfahren nach Anspruch 24, **dadurch gekennzeichnet, daß** am Ende des Verfahrensschritts d) sowohl das erste als auch das zweite Substratpaket so weit angehoben wird, daß während des Drehens der Haltestange (7, 21) gemäß Verfahrenschritt e) keine Substrate (3) auf der Haltestange (7, 21) aufliegen.

## Claims

1. Device for treatment of substrates (3) in a fluid container (1) with a substrate transport device (5, 20) which can be brought above the fluid container (1), is constructed as a processing hood and comprises at least one rotatable securing rod (7, 21), which extends over the width of a substrate package and which can be brought by rotation from a first position in which the substrates (3) are secured to a second position in which the substrates (3) are released, wherein the securing rod (7, 12) is arranged in at least one wall (9 or 22) of the transport device (5, 20), and two opposite walls (8, 9 or 22) of the transport device (5, 20) have slots (23) for the substrates (3), and wherein in the first position edge regions of the substrates (3) rest on the securing rod (7, 21) and the substrates (3) can in the second position be brought out of or into the transport device (5, 20).

2. Device according to claim 1, **characterised in that** the securing rod (7, 21) has at least one area (11) which in the first position, in which the substrates (3) are secured, projects into the interior of the transport device (5, 20).

3. Device according to one of the preceding claims, **characterised in that** the securing rod (7, 21) in the second position, in which the substrates (3) are released, is flush with the inner surface of the wall (9, 22) of the transport device (5, 20).

4. Device according to one of the preceding claims, **characterised in that** the securing rod (7, 21) comprises at least two different projections.

5. Device according to one of the preceding claims, **characterised in that** the securing rod (7, 21) has a substantially rectangular cross-section.

6. Device according to one of the preceding claims, **characterised in that** the securing rod (7, 21) has a polygonal cross-section.

7. Device according to one of the preceding claims, **characterised in that** the securing rod (7, 21) has in the longitudinal region, against which the substrates (3) bear in the first position in which the substrates are secured, slots (31, 35) for the substrates (3).

8. Device according to claim 4 or 5, **characterised in that** the projections (11) and/or polygonal slots (31, 35) have different spacings.

9. Device according to claim 7 or 8, **characterised in that** the spacings between the slots (31, 35) of the securing rod correspond with the spacings between the substrates (3) of a substrate package.

10. Device according to claim 7 or 8, **characterised in that** the spacings between the slots (31, 35) of the securing rod is half the size of the spacings between the substrates of a substrate package to be transported.

11. Device according to one of the preceding claims, **characterised in that** the securing rod (7, 21) has a third position in which a first part of the substrates (3) is secured and a second part is released.

12. Device according to claim 11, **characterised in that** every other substrate (3) is secured and every intermediate substrate is releasable.

13. Device according to one of the preceding claims, **characterised in that** the securing rod (7, 21) in its first, second and/or third position seals the wall (9) to the exterior.

14. Device according to one of the preceding claims, **characterised in that** the transport device (5, 20) has inlet openings for at least one fluid.

15. Device according to one of the preceding claims, **characterised in that** the transport device (5, 20) is provided for a drying process according to the Marangoni method.

16. Device according to one of the preceding claims, **characterised in that** the transport device (5, 20) comprises a closing device at the side facing the fluid container (1).

17. Device according to one of the preceding claims, **characterised by** a loading and/or unloading station (40) for loading and/or unloading the processing head (5, 20).

18. Device according to claim 17, **characterised by** a substrate support holder (41) positionable under the transport device (5, 20).

19. Device according to claim 8, **characterised in that** the substrate support holder (41) has at least two displacement positions which are staggered in the direction of the substrate package axis relative to one another by half the spacing of the substrates.

20. Device according to one of claims 17 to 19, **characterised in that** the loading and/or unloading station (40) comprises a substrate lifting device (44) for lifting and/or lowering the substrates (3) into the transport device (5, 20) or out of the transport device (5, 20).

21. Device according to claim 20, **characterised in that** the substrate lifting device (44) has at least one stay extending over the width of the substrate package.

22. Device according to claim 20 or 21, **characterised in that** the substrate lifting device (44) at its support surfaces or edges has slots or notches, the spacings of which are half the size of the spacings of the substrates in the substrate support.

23. Method of transporting substrates by a device according to one of the preceding claims, **characterised in that** the process for loading the transport device (5) with the substrates (3) has the following steps:
a) rotation of the securing rod into the second position in which the substrates (3) are released,
b) insertion of the substrates into the transport device (5, 20) until at least the widest regions of the substrates (3) are positioned above the securing rod (7, 21), and
c) rotation of the securing rod (7, 21) into the first position in which the substrates (3) are secured.

24. Method according to claim 23, **characterised in that** the process for loading the transport device (5) with the substrates (3) includes the following method steps:
a) rotation of the securing rod (7, 21) into the second position in which the substrates (3) are released,
b) insertion of the substrates (3) of a first substrate package into the transport device (5, 20) until at least the widest regions of the substrates (3) are positioned above the securing rod (7, 21),
c) rotation of the securing rod (7, 21) into the third position in which the inserted substrate package is secured by the securing rod (7, 21),
d) insertion of a second substrate package which in its position relative to the first substrate package is displaced by half the substrate spacing in the longitudinal direction of the securing rod (7, 21), and
e) rotation of the securing rod (7, 21) into the second position in which all substrates are secured.

25. Method according to claim 24, **characterised in that** at the end of the method step d) the first as well as the second substrate package are lifted to such an extent that during the rotation of the securing rod (7, 21) according to method step e) no substrates (3) contact the securing rod (7, 21).

## Revendications

1. Dispositif de traitement de substrats (3) dans un récipient de fluide (1), avec une installation de transport de substrats (5, 20) pouvant être amenée au-dessus du récipient de fluide (1), réalisée sous forme de capot de traitement, qui présente au moins une tige de retenue tournante (7, 21) s'étendant sur la largeur d'un paquet de substrats, qui peut être amenée par rotation d'une première position, tenant les substrats (3), dans une deuxiême position, libérant les substrats (3), où la tige de retenue (7, 12) est disposée dans au moins une paroi (9 respectivement 22) de l'installation de transport (5, 20) et deux parois opposées (8, 9 respectivement 22) de l'installation de transport (5, 20) présentent des fentes (23) pour les substrats (3), et où dans la première position de la tige de retenue (7, 21), des zones d'arête des substrats viennent en appui et les substrats (3) peuvent être amenés dans la deuxième position hors de l'installation de transport (5, 20) ou dans celle-ci.

2. Dispositif selon la revendication 1, **caractérisé en ce que** la tige de retenue (7, 21) préuente au moins une zone (11) qui fait saillie dans la première position, tenant les substrats (3), dans l'espace intérieur de l'installation de transport (5, 20).

3. Dispositif selon l'une des revendications précédentes, **caractérisé en ce que** la tige de retenue (7, 21), dans la deuxième position, libérant les substrats (3), se termine en affleurement avec la face intérieure de la paroi (9, 22) de l'installation de transport (5, 20).

4. Dispositif selon l'une des revendications précédentes, **caractérisé en ce que** la tige de retenue (7, 21) présente au moine deux saillies différentes.

5. Dispositif aelon l'une des revendications précédentes, **caractérisé en ce que** la tige de retenue (7, 21) présente une section transversale sensiblement rectangulaire.

6. Dispositif selon l'une des revendications précédentes, **caractérisé en ce que** la tige de retenue (7, 21) présente une section transversale polygonale.

7. Dispositif selon l'une des revendications précédentes, **caractérisé en ce que** la tige de retenue (7, 21) présente dans la zone longitudinale à laquelle les substrats (3) s'appliquent dans la première position tenant les substrats, des fentes (31, 35) pour les substrats (3).

8. Dispositif selon la revendication 4 ou 6, **caractérisé en ce que** les saillies (11) et/ou faces polygonales présentent des fentes (31, 35) avec des écarts différents.

9. Dispositif selon la revendications 7 ou 8, **caractérisé en ce que** les écarts entre les fentes (31, 35) de la tige de retenue correspondent aux écarts entre les substrats (3) d'un paquet de substrats.

10. Dispositif selon la revendication 7 ou 8, **caractérisé en ce que** les écarts entre les fentes (31, 35) de la tige de retenue représentent la moitié des écarts entre les substrats d'un paquet de substrats à transporter.

11. Dispositif selon l'une des revendications précédentes, **caractérisé en ce que** la tige de retenue (7, 21) présente une troisième position dans laquelle est tenue une première partie des substrats (3), et une deuxième partie est libérée.

12. Dispositif selon la revendication 11, **caractérisé en ce que** respectivement chaque deuxième substrat (3) est tenu et chaque substrat situé entre peut être libéré.

13. Dispositif selon l'une des revendications précédentes, **caractérisé en ce que** la tige de retenue (7. 21), dans sa première, deuxième et/ou troieième position rend étanche la paroi (9) vers l'extérieur.

14. Dispositif selon l'une des revendications précédentes, **caractérisé en ce que** l'installation de transport (5, 20) présente des ouvertures d'admission pour au moine un fluide.

15. Dispositif selon l'une des revendications précédentes, **caractérisé en ce que** l'installation de transport (5, 20) est prévue pour un processus de séchage selon le procédé de Marangoni.

16. Dispositif selon l'une des revendications précédentes, **caractérisé en ce que** l'installation de transport (5, 20) comprend un dispositif de fermeture au côté orienté vers le récipient de fluide (1).

17. Dispositif selon l'une des revendications précédentes, **caractérisé par** un poste de chargement et/ou de déchargement (40) pour charger er/ou décharger le capot de traitement (5, 20).

18. Dispositif selon la revendication 17, **caractérisé par** un support de porte-substrats (41) pouvant être amené sous l'installation de transport (5, 20).

19. Dispositif selon la revendication 18, **caractérisé en ce que** le support de porte-substrats (41) présente au moins deux positions de déplacement qui sont décalées dans la direction de l'axe dea paquets de substrats l'une de l'autre d'un demi-écart de substrat.

20. Dispositif selon l'une des revendications 17 à 19, **caractérisé en ce que** le poste de chargement et/ou déchargement (40) présente un dispositif de relevage de substrats (44) pour relever et/ou abaisser les substrats (3) dans l'installation de transport (5, 20) respectivement de l'installation de transport (5, 20).

21. Dispositif selon la revendication 20, **caractérisé en ce que** le dispositif de relevage de substrats (44) est au moins une baguette s'étendant sur la largeur du paquet de substrats.

22. Dispositif selon la revendication 20 ou 21, **caractérisé en ce que** le dispositif de relevage de substrats (44) présente à ses faces ou arêtes d'application des fentes ou des entailles dont les écarts représentent la moitié des écarts des substrats dans le porte-substrats.

23. Procédé de transport de substrats avec un dispositif selon l'une des revendications précédentes, **caractérisé en ce que** l'opération de chargement de l'installation de transport (5) avec les substrats (3) comprend les étapes de procédé suivantes :
a) tourner la tige de retenue dans la deuxième position libérant les substrats (3),
b) pousser les substrats dans l'installation de transport (5, 20) jusqu'à ce qu'au moins les zones les plus larges des substrats (3) se trouvent au-dessus de la tige de retenue (7, 21) et
c) tourner la tige de retenue (7, 21) dans la première position retenant les substrats (3).

24. Procédé selon la revendication 23, **caractérisé en ce que** l'opération de chargement de l'installation de transport (5) avec les substrats (3) comprend les étapes de procédé suivantes :
a) tourner la tige de retenue (7, 21) dans la deuxième position libérant les substrats (3),
b) pousser les substrats (3) d'un premier paquet de substrats dans l'installation de transport (5, 20) jusqu'à ce qu'au moins les zones les plus larges des substrats (3) se trouvent au-dessus de la tige de retenue (7, 21),
c) tourner la tige de retenue (7, 21) dans la troisième position dans laquelle le paquet de substrats inséré est tenu par la tige de retenue (7, 21),
d) insérer par poussée un deuxième paquet de substrats qui, dans sa position relativement au premier paquet de substrats, est décalé d'un demi-écart de substrat dans la direction longitudinale de la tige de retenue (7, 21) et
e) tourner la tige de retenue (7, 21) dans la deuxième position dans laquelle tous les substrats sont tenus.

25. Procédé selon la revendication 24, **caractérisé en ce qu'**à la fin de l'étape de procédé d) à la fois le premier et aussi le deuxième paquet de substrats est relevé suffisamment pour que pendant la rotation de la tige de retenue (7, 21) selon l'étape de procédé e) il n'y ait pas de substrats (3) qui reposent sur la tige de retenue (7, 21).
